# DEMANDE DE BREVET EUROPEEN

(11) **EP 2 832 899 A1**
(43) Date de publication de la demande: **04.02.2015**
(21) Numéro de dépôt: 13179159.2
(22) Date de dépôt: 02.08.2013
(51) Int. Cl.: C30B 29/04, C30B 25/14, C30B 25/16, C30B 28/14, C23C 28/00, C23C 28/04, C23C 16/27

(54) **Revêtement de diamant et procédé de dépôt d'un tel revêtement**

(71) Demandeur: The Swatch Group Research and Development Ltd., 2074 Marin (CH)
(72) Inventeur: Merzaghi, Sebastiano, 1018 Lausanne (CH); Fauro, Cédric, 2016 Cortaillod (CH); Dubois, Philippe, 2074 Marin (CH)
(74) Mandataire: Ravenel, Thierry Gérard Louis

(57) **Abrégé**

L'invention concerne un revêtement de diamant caractérisé en ce qu'il comprend au moins un empilement d'une première couche de diamant nanocristallin et d'une deuxième couche de diamant microcristallin.

## Description

La présente invention concerne un revêtement de diamant et en particulier un tel revêtement de diamant microcristallin (MCD, d'après la dénomination anglaise Microcristalline Diamond ) présentant une rugosité Ra inférieure à 20 nanomètres, par exemple pour des applications tribologiques dans le domaine de la micromécanique.

L'invention concerne également un procédé de dépôt d'un tel revêtement de diamant économique à mettre en oeuvre. La présente invention concerne plus particulièrement un tel procédé prévu pour être appliqué à des pièces de micromécanique agencées pour être en contact par frottement avec d'autres pièces relativement auxquelles elles sont en mouvement. Ces pièces de micromécanique peuvent être aussi bien des pièces mobiles, comme des pièces pivotées par exemple, que des pièces fixes, comme les paliers par exemple. Il s'agit par exemple, mais de façon non limitative, de pièces de micromécanique d'un mouvement horloger mécanique.

L'invention concerne en outre une pièce de micromécanique comprenant un substrat présentant une surface fonctionnelle revêtue d'un revêtement de diamant.

Il est bien connu dans l'art antérieur de revêtir des substrats d'un revêtement de diamant microcristallin pour augmenter la résistance à l'usure dudit substrat et d'autre part réduire le frottement.

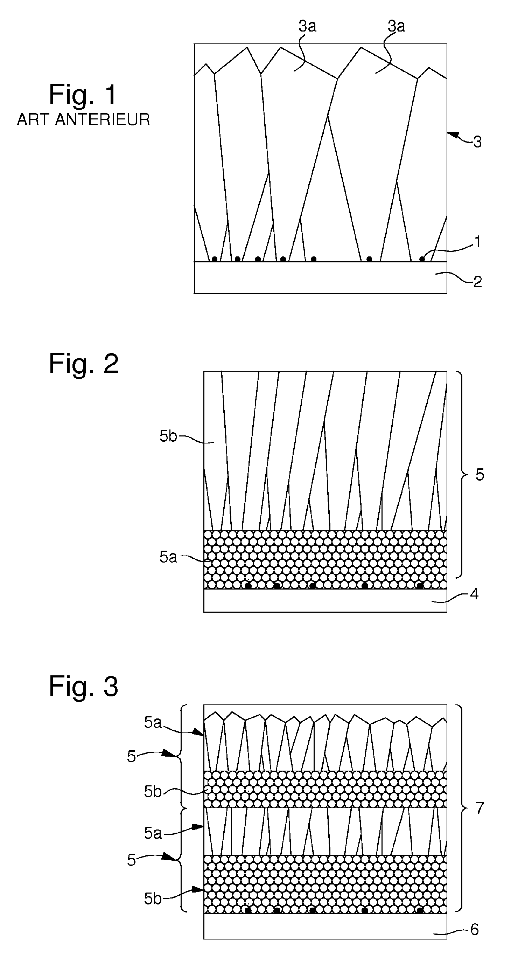

A la figure 1 est illustrée de manière schématique une couche microcristalline selon l'art antérieur. Pour réaliser ces revêtements de diamant monocristallin, on crée une couche de germination 1 à la surface du substrat 2 à revêtir. Cette couche de germination comprend par exemple des germes formés de nanoparticules de diamant répartis à la surface du substrat avec une densité de recouvrement de l'ordre de 10¹⁰ particules/cm². Le substrat est alors placé dans un réacteur de dépôt chimique en phase vapeur (CVD) à filament chaud ou à plasma dans lequel un mélange de gaz, typiquement un mélange de méthane et d'hydrogène est injecté. Dans des conditions de pressions, températures et flux de gaz déterminées, des microcristaux de diamant 3 croissent de manière colonnaire à partir des germes jusqu'à l'épaisseur de revêtement souhaitée. Les microcristaux présentent typiquement une forme colonnaire pyramidale s'évasant à partir du substrat de sorte que la taille des grains augmente avec l'épaisseur de la couche comme cela est illustré à la figure 1.

Pour les applications tribologiques et de résistances à l'usure typique, on utilise des couches de diamant présentant une épaisseur de l'ordre de 0.5 à 10 micromètres. Avec de telles épaisseurs, la taille des grains en surface dépasse les 200nm et la rugosité (Ra) peut atteindre des valeurs supérieures à 50nm, ce qui ne permet pas d'atteindre des conditions de frottement satisfaisantes dans bon nombre d'applications.

Pour remédier à cet inconvénient, l'homme de métier est donc contraint de procéder à une ou plusieurs opérations de polissage subséquentes au dépôt pour diminuer la rugosité. Typiquement ces opérations de polissage sont réalisées mécaniquement ou par procédé plasma. Dans tous les cas, ces opérations de polissage sont longues, délicates, coûteuses et ne donnent pas un résultat suffisant pour certaines applications, notamment pour le revêtement de pièces de micromécaniques horlogères telles que des levées et/ou dents de roues d'échappement.

La présente invention a donc pour but de pallier ces inconvénients en fournissant un revêtement de diamant et en particulier un revêtement de diamant microcristallin présentant une rugosité Ra inférieure à 20 nanomètres, qui est plus facile à obtenir et plus économique à mettre en oeuvre que les revêtements de l'art antérieur.

L'invention a également pour but de fournir un revêtement de diamant microcristallin présentant des propriétés mécaniques améliorées sur son épaisseur.

L'invention a également pour but de fournir un revêtement de diamant microcristallin présentant à surface extérieure visible une taille de grain inférieure à 100 nm quelle que soit l'épaisseur totale du revêtement de l'invention.

L'invention a également pour but de fournir un revêtement de diamant microcristallin présentant surface extérieure d'un aspect esthétique amélioré, notamment présentant une réflectivité améliorée et permettant des applications dans le domaine de l'optique.

A cet effet, la présente invention concerne un revêtement de diamant **caractérisé en ce qu'il** comprend au moins un empilement d'une première couche de diamant nanocristallin et d'une deuxième couche de diamant microcristallin.

Grâces à ces caractéristiques, la présente invention procure la possibilité de réaliser des revêtements en diamant microcristallin épais c'est-à-dire supérieure à 1 micromètre présentant en surface une taille de grains et une rugosité associée inférieure à celles d'une couche de diamant microcristallin de même épaisseur. Ceci résulte du fait que la croissance des monocristaux microcristallins est faite à partir d'une couche de germination formée par la couche de diamant nanocristallin qui est beaucoup plus dense qu'une couche de germination classique formée de nanoparticules de diamant.

Selon un mode de réalisation préféré, le revêtement de l'invention comprend une succession d'au moins deux desdits empilements dans laquelle la couche de diamant microcristallin d'un premier empilement est en contact avec la couche de diamant nanocristallin de l'empilement suivant.

Comme la croissance colonnaire pyramidales est réinitialisée à chaque empilement formant le revêtement cela permet par la succession des empilements de l'invention d'obtenir une épaisseur de revêtement importante avec une taille de grains et une rugosité d'un seul empilement d'une épaisseur choisie.

Avantageusement, l'épaisseur de la couche nanocristalline est comprise entre 50 nanomètres et 1 micromètre et l'épaisseur de la couche microcristalline est comprise entre 100 nanomètres et 1 micromètres, et de manière préférée l'épaisseur de la couche nanocristalline est comprise entre 100 et 200 nanomètres et l'épaisseur de la couche microcristalline est comprise entre 200 et 500 nanomètres.

De préférence, la taille des grains de de la surface de la couche de diamant nanocristallin est inférieure à 50 nanomètres et en particulier inférieure à 30 nanomètre et de manière encore plus préférée inférieure à 10 nanomètres.

De préférence, la taille des grains de de la surface extérieure visible du revêtement de l'invention est de l'ordre de 100 nanomètres.

L'invention a également pour objet une pièce de micromécanique comprenant un substrat présentant une surface fonctionnelle, dans laquelle la surface fonctionnelle est revêtue d'un revêtement de diamant comprenant au moins un empilement d'une première couche de diamant nanocristallin et d'une deuxième couche de diamant microcristallin, ladite surface fonctionnelle du substrat étant en contact avec la couche de diamant nanocristallin dudit revêtement.

Avantageusement, le substrat est choisi parmi l'ensemble de matériaux comprenant le silicium, le titane, le zirconium, le hafnium, le vanadium, le tantale, le molybdène, le tungstène, le bore, les borures, les carbures, les nitrures et les oxydes de ces derniers ainsi que les céramiques.

Selon des modes de réalisation préférés la pièce de micromécanique de l'invention peut être une roue dentée, un pignon, une roue d'échappement , une ancre, une palette, un ressort, un ressort de barillet, un spiral, un axe et/ou des paliers de pivotement.

L'invention concerne également un procédé de dépôt d'un revêtement de diamant sur un substrat par dépôt chimique en phase vapeur dans une chambre de réaction, ce procédé comprenant au moins :
a) une étape de préparation du substrat,
b) une étape de germination initiale,
c) une étape de croissance du revêtement sur une surface du substrat, l'étape de croissance comportant au moins une séquence de deux phases successives comprenant une phase de croissance de diamant nanocristallin pour former une couche de diamant nanocristallin, suivie d'une autre phase de croissance de diamant microcristallin, la couche de diamant nanocristallin étant utilisée comme couche de germination pour la croissance de la couche de diamant microcristallin.
De préférence l'étape c) est répétée une pluralité de fois.

Avantageusement durant la phase de croissance de diamant nanocristallin de l'étape c), les paramètres de dépôt sont ajustés pour que la taille des grains de diamant nanocristallin ne dépasse pas 50 nanomètres et de préférence 30 nanomètres et de manière encore plus préférée 10 nanomètres, et la durée de la phase de croissance de diamant microcristallin de l'étape c), est ajustée pour d'atteindre une épaisseur diamant microcristallin comprise entre 200 nanomètres et 1 micromètres et de préférence comprise entre 200 et 500 nanomètres.

De préférence la durée de la phase de croissance de diamant nanocristallin de l'étape c), permet d'atteindre une épaisseur diamant nanocristallin comprise entre 100 et 200 nanomètres.

De préférence, le substrat est choisi parmi l'ensemble de matériaux comprenant le silicium, le titane, le zirconium, le hafnium, le vanadium, le tantale, le molybdène, le tungstène, le bore, les borures, les carbures, les nitrures et les oxydes de ces derniers ainsi que les céramiques.
Avantageusement, le procédé est mis en oeuvre dans un réacteur à filament chaud et la température du substrat durant l'étape c) est comprise entre 500 et 1000°C.

Selon un mode réalisation préféré la phase de phase de croissance de diamant nanocristallin est mise en oeuvre dans les conditions suivantes :
- durée comprise entre 1 h et 5h,
- chauffage, respectivement activation direct ou indirect, d'un mélange de gaz CH₄/H₂/X dans lequel X représente un gaz dopant, avec un pourcentage en volume de gaz dopant compris entre 0% et 10%, et avec un pourcentage en volume de CH₄ par rapport au volume total compris entre 3% et 9%,
- le débit d'hydrogène rapporté à la pression de 1 bar est compris entre 20 et 50 litres/min et de préférence 40 litres/min ,
- la pression du mélange de gaz dans la chambre est comprise entre 2 et 6 mbar,
- la température du substrat est comprise entre 500 et 1000°C,
et la phase de croissance de diamant microcristallin est mise en oeuvre dans les conditions suivantes :
- durée comprise entre 1 h et 5h,
- chauffage, respectivement direct ou indirect, d'un mélange de gaz CH₄/H₂/X dans lequel X représente un gaz dopant, avec un pourcentage en volume de gaz dopant compris entre 0% et 10%, et avec un pourcentage en volume de CH₄ par rapport au volume total compris entre 0,05% et 1 %,
- le débit d'hydrogène rapporté à la pression de 1 bar est compris entre 30 et 90 litres/min et de préférence 60 litres/min,
- la pression du mélange de gaz dans la chambre est comprise entre 0.5 et 2 mbar et
- la température du substrat est comprise entre 500 et 1000°C.

### Description sommaire des dessins

Les caractéristiques de l'invention apparaîtront plus clairement à la lecture de la description d'une forme d'exécution préférentielle de l'invention, donnée uniquement à titre d'exemple, nullement limitative en se référant aux figures schématiques, dans lesquelles:
- la figure 1, déjà décrite, représente une coupe schématique d'un substrat recouvert d'un revêtement en diamant microcristallin selon l'art antérieur ;
- la figure 2 représente en coupe un substrat recouvert d'un revêtement en diamant microcristallin comprenant un empilement selon l'invention ;
- la figure 3 représente en coupe un substrat recouvert d'un revêtement en diamant microcristallin comprenant une pluralité d'empilements selon l'invention ;
- les figures 4a et 4b sont respectivement des photographies de microscopie électronique à balayage vue de dessus d'un substrat revêtu d'un revêtement de diamant microcristallin selon l'invention et selon l'art antérieur.

En se référant à la figure 1 on voit un substrat 2 recouvert d'un revêtement de diamant microcristallin 3 déposé selon un procédé de dépôt conventionnel. On remarque que la croissance microcristalline est initiée par des germes 1, formées de nanoparticules de diamant, répartis à la surface du substrat 2 et conduit à une couche formée de cristaux présentant une géométrie colonnaire pyramidale s'évasant à partir de la surface du substrat. Lorsque l'épaisseur de la couche 3 augmente, la taille des cristaux grandit et s'ensuit un accroissement de la taille des grains à la surface extérieure visible du revêtement. Cet accroissement de la taille des grains conduit à une augmentation de la rugosité qui peut être gênante selon l'application du revêtement envisagée.

En se référant à la figure 2, on voit un substrat 4 recouvert d'un revêtement de diamant microcristallin 5 déposé selon le procédé de dépôt de l'invention.

Contrairement au revêtement de l'art antérieur qui est formé d'une monocouche de diamant microcristallin 3, le revêtement de diamant monocristallin est formé d'un empilement d'une première couche de diamant nanocristallin 5a et d'une deuxième couche de diamant microcristallin 5b comme cela apparait à la figure 2.

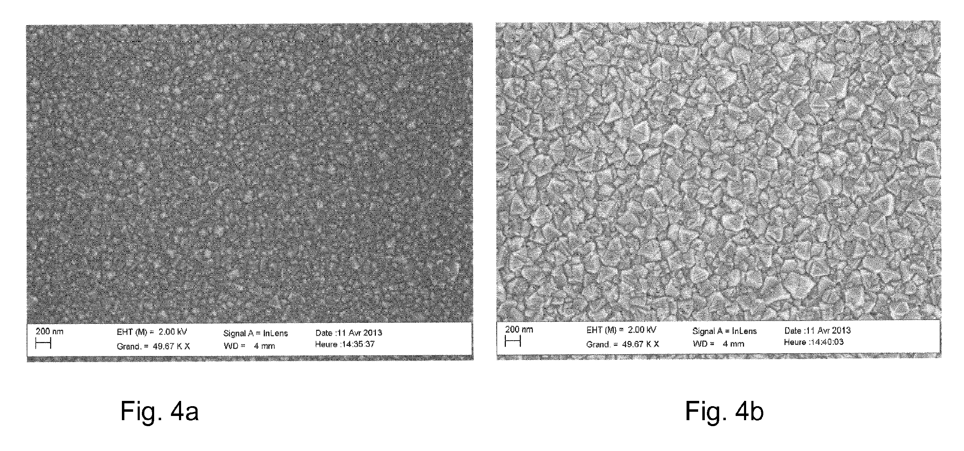

On constate que pour une même épaisseur de revêtement de diamant microcristallin en surface, la taille des grains à la surface extérieure visible du revêtement est moindre et par conséquent que la rugosité est diminuée par rapport aux revêtements de l'art antérieur. Ceci résulte du fait que la germination pour la couche de diamant microcristallin est réalisée à partir de la couche de diamant nanocristallin qui est une couche fermée, qui offre un nombre de sites de croissance plus dense et plus homogène que les germes classiques formées de nanoparticules de diamant simplement réparties à la surface du substrat à revêtir. A titre d'exemple, pour une épaisseur de la couche nanocristalline de l'ordre de 100 nanomètres et une épaisseur de la couche microcristalline de l'ordre de 200 nanomètres, la réduction de la taille des grains obtenues est de l'ordre de 50% et la réduction de la rugosité Ra est de l'ordre de 30%. Ceci apparait clairement sur les figures 4a et 4a représentant.

De plus, à épaisseur de revêtement de diamant égale, la couche de diamant microcristallin du revêtement de l'invention est plus mince que celle du revêtement de diamant microcristallin de l'art antérieur, ceci résultant de la nature stratifiée du revêtement de diamant de l'invention. Cette diminution de l'épaisseur de couche de diamant microcristallin dans le revêtement de diamant de l'invention contribue également à la diminution de la taille des grains et de la rugosité Ra de la surface extérieure du revêtement.

En se référant à la figure 3, on voit un substrat 6 sur lequel a été déposé une variante de réalisation d'un revêtement 7 selon l'invention. Dans cette variante, le revêtement comprend une succession de deux empilements 5 tels que décrits en liaison avec la figure 2.

Les figures 4a et 4b montrent des photographies de microscopie électronique à balayage vue de dessus d'un substrat revêtu d'un revêtement de diamant microcristallin dans lesquelles la couche terminale de diamant microcristallin a été déposée dans des conditions identiques (ensemble dans un même réacteur) , selon l'invention à partir d'une couche nanocristalline (figure 4a) et selon l'art antérieur à partir de nanoparticules de diamant réparties à la surface du substrat. On remarque clairement que la taille des grains de la couche du revêtement de l'invention est 50% inférieure (typiquement de 100 nanomètres pour une épaisseur de couche de diamant microcristallin de 250 nanomètres) à celle de l'art antérieur (typiquement de 200 nanomètres pour une épaisseur de couche de diamant microcristallin de 250 nanomètres) et que la rugosité Ra de la couche du revêtement de l'invention est réduite de 30 % par rapport à celle de l'art antérieur.

On va décrire ci-après un exemple de dépôt du revêtement de diamant microcristallin selon l'invention sur un substrat formé d'une plaquette en silicium comportant des pièces de micromécaniques à revêtir, ces dernières étant maintenues à la plaquette par des attaches sécables.

Le dépôt du revêtement 5 sur le substrat 4 est effectué par dépôt chimique en phase vapeur (CVD) dans une chambre de réaction à filament chaud.

Préalablement à la mise en place dans la chambre de réaction, le substrat 4 est nettoyé dans un bain d'acide fluoridrique notamment pour éliminer la couche d'oxyde natif et favoriser la fixation des nanoparticules de diamant à sa surface qui serviront à la croissance de la première couche de diamant nanocristallin.

Le substrat 4 est ensuite placé dans un bain comprenant un solvant, typiquement de l'isopropanol et des nanoparticules de diamant en suspension. La taille des nanoparticules est typiquement comprises entre 5 et 15 nanomètres. Le bain est alors agité au moyens d'ultrasons pour fixer les nanoparticules de diamant à la surface du substrat.

Le substrat 4 est ensuite séché à l'air ou sous un flux de gaz neutre, par exemple un flux d'azote pour terminer l'étape de préparation du substrat.

Le substrat préparé est ensuite disposé dans la chambre de réaction sur un support de maintien, de préférence autorisant un libre circulation des gaz autour du substrat, puis la chambre est mise sous vide, typiquement avec un vide inférieur à 1 mbar.

Le substrat est alors chauffé directement via un corps de chauffe et/ou indirectement par rayonnement à partir des filaments du réacteur jusqu'à une température de dépôt. Typiquement la température de dépôt est comprise entre 500 et 1000°C, par exemple à une température de l'ordre de 750°C.

Une fois la température de dépôt atteinte, un mélange de CH₄/H₂ gazeux est injecté dans la chambre de réaction. Le pourcentage de CH₄ par rapport au volume total est compris entre 3% et 9% et de préférence de 6% et le débit d'hydrogène rapporté à la pression de 1 bar est compris entre 20 et 50 litres/min et de préférence 40 litres/min. La pression du mélange de gaz dans la chambre est alors comprise entre 2 et 6 mbar et préférence de 4 mbar. Ces conditions initient l'étape de germination et de croissance de diamant nanocristallin à partir des nanoparticules de diamant et correspondent à l'étape de germination initiale.

Les conditions de l'étape de germination initiales sont ensuite maintenues pour faire croitre la couche de diamant nanocristallin au minimum sur une épaisseur permettent de former la couche de diamant nanocristallin, typiquement sur une épaisseur de 100 nanomètres.

Cette épaisseur peut bien entendu varier et atteindre l'ordre du micron en fonctions de la dureté du revêtement final que l'on souhaite obtenir sachant que la dureté du revêtement de l'invention sera plus faible si l'épaisseur relative de la couche de diamant nanocristallin du revêtement est grande.

Cette croissance de diamant nanocristallin constitue une phase de l'étape de croissance du revêtement de diamant de l'invention.

Une fois l'épaisseur désirée de diamant nanocristallin atteinte, les conditions dans la chambre de réaction sont modifiées pour permettre la croissance d'une couche de diamant microcristallin. A cet effet, le pourcentage de CH₄ par rapport au volume total du mélange gazeux CH₄/H₂ est modifié et passe à une valeur comprise entre 0,05% et 1% et préférentiellement à 0,1% et le débit d'hydrogène rapporté à la pression de 1 bar passe à une valeur comprise entre 30 et 90 litres/min préférentiellement à 60 litres/min. La pression du mélange de gaz dans la chambre est alors ramenée à une valeur comprise 0,5 et 2 mbar et préférence de 1 mbar. Dans ces conditions de dépôt, la croissance du diamant se fait sous une forme microcristalline, les grains de la couche nanocristalline sous-jacente constituant les germes de la couche microcristalline à venir.

La phase de croissance de la couche de diamant microcristallin est interrompue une fois l'épaisseur souhaitée atteinte. Pour obtenir une couche de diamant microcristallin présentant en surface une taille de grains réduite (typiquement de l'ordre de 100 nanomètres) et une rugosité Ra inférieure à 20 nm apte à être utilisée dans des applications tribologiques, l'épaisseur de la couche de diamant microcristallin ne devrait de préférence pas dépasser 500 nm.

Pour des applications dans lesquelles une épaisseur de revêtement de diamant supérieure à 1 micromètre est souhaitable, la séquence de dépôts successifs de couche de diamant nanocristallin et de diamant microcristallin sera répétée jusqu'à atteindre l'épaisseur souhaitée.

Il va de soi que l'invention n'est pas limitée au mode de réalisation qui vient d'être décrit et que diverses modifications et variantes simples peuvent être envisagées par l'homme du métier sans sortir du cadre de l'invention tel que défini par les revendications annexées.

## Revendications

1. Revêtement de diamant **caractérisé en ce qu'il** comprend au moins un empilement d'une première couche de diamant nanocristallin et d'une deuxième couche de diamant microcristallin.

2. Revêtement de diamant selon la revendication 1, **caractérisé en ce qu'il** comprend une succession d'au moins deux desdits empilements dans laquelle la couche de diamant microcristallin d'un premier empilement est en contact avec la couche de diamant nanocristallin de l'empilement suivant.

3. Revêtement de diamant selon l'une des revendications 1 ou 2, **caractérisé en ce que** l'épaisseur de la couche de diamant nanocristallin est comprise entre 50 nanomètres et 1 micromètre.

4. Revêtement de diamant selon la revendication 3, **caractérisé en ce que** l'épaisseur de la couche de diamant nanocristallin est comprise entre 100 et 200 nanomètres.

5. Revêtement de diamant selon l'une des revendications précédentes, **caractérisé en ce que** l'épaisseur de la couche de diamant microcristallin est comprise entre 100 nanomètres et 1 micromètres.

6. Revêtement de diamant selon la revendication 5, **caractérisé en ce que** l'épaisseur de la couche de diamant microcristallin est comprise entre 200 et 500 nanomètres.

7. Revêtement de diamant selon l'une des revendications précédentes, **caractérisé en ce que** la taille des grains en surface de la couche de diamant nanocristallin est inférieure à 50 nanomètres et de préférence inférieure à 30 nanomètres et de manière encore plus préférée inférieure à 10 nanomètres.

8. Pièce de micromécanique comprenant un substrat présentant une surface fonctionnelle, **caractérisée en ce que** ladite surface fonctionnelle est revêtue d'un revêtement selon l'une quelconque des revendications 1 à 7 et **en ce que** ladite surface fonctionnelle est en contact avec la couche de diamant nanocristallin dudit revêtement.

9. Pièce de micromécanique selon la revendication 8, **caractérisée en ce que** le substrat est choisi parmi l'ensemble de matériaux comprenant le silicium, le titane, le zirconium, le hafnium, le vanadium, le tantale, le molybdène, le tungstène, le bore, les borures, les carbures, les nitrures et les oxydes de ces derniers ainsi que les céramiques.

10. Pièce de micromécanique selon la revendication 8 ou 9, **caractérisée en ce qu'**elle comprend une roue dentée, un pignon, une roue d'échappement , une ancre, une palette, un ressort, un ressort de barillet, un spiral, un axe et/ou des paliers de pivotement.

11. Procédé de dépôt d'un revêtement de diamant sur un substrat par dépôt chimique en phase vapeur dans une chambre de réaction, ce procédé comprenant au moins :
a) une étape de préparation du substrat,
b) une étape de germination initiale,
c) une étape de croissance, l'étape de croissance comportant au moins une séquence de deux phases successives comprenant une phase de croissance de diamant nanocristallin pour former une couche de diamant nanocristallin, suivie d'une autre phase de croissance de diamant microcristallin, la couche de diamant nanocristallin étant utilisée comme couche de germination pour la croissance de la couche de diamant microcristallin.

12. Procédé de dépôt selon la revendication 11, **caractérisé en ce que** l'étape c) est répétée une pluralité de fois.

13. Procédé de dépôt selon la revendication 11 ou 12, **caractérisé en ce que** durant la phase de croissance de la couche de diamant nanocristallin de l'étape c), les paramètres de dépôt sont ajustés pour que la taille des grains de diamant nanocristallin ne dépasse pas 50 nanomètres et de préférence 30 nanomètres et de manière encore plus préférée 10 nanomètres.

14. Procédé de dépôt selon l'une des revendications 11 à 13, **caractérisé en ce que** la durée de la phase de croissance de diamant microcristallin de l'étape c), permet d'atteindre une épaisseur diamant microcristallin comprise entre 200 nanomètres et 1 micromètres et de préférence comprise entre 200 et 500 nanomètres.

15. Procédé de dépôt selon l'une des revendications 11 à 14, **caractérisé en ce que** la durée de la phase de croissance de diamant nanocristallin de l'étape c), permet d'atteindre une épaisseur diamant nanocristallin comprise entre 100 et 200 nanomètres.

16. Procédé de dépôt selon l'une des revendications 11 à 15, **caractérisé en ce que** le substrat est choisi parmi l'ensemble de matériau comprenant le silicium, le titane, le zirconium, le hafnium, le vanadium, le tantale, le molybdène, le tungstène, le bore, les borures, les carbures, les nitrures et les oxydes de ces derniers ainsi que les céramiques.

17. Procédé de dépôt selon l'une des revendications 11 à 16 **caractérisé en ce qu'il** est mis en oeuvre dans un réacteur à filament chaud.

18. Procédé de dépôt selon l'une des revendications 11 à 17 **caractérisé en ce que** la température du substrat durant l'étape c) est comprise entre 500 et 1000°C.

19. Procédé de dépôt selon l'une des revendications 11 à 18 **caractérisé en ce que** la phase de phase de croissance de diamant nanocristallin est mise en oeuvre dans les conditions suivantes :
• durée comprise entre 1 h et 5h,
• chauffage, respectivement activation direct ou indirect, d'un mélange de gaz CH₄/H₂/X dans lequel X représente un gaz dopant, avec un pourcentage en volume de gaz dopant compris entre 0% et 10%, et avec un pourcentage en volume de CH₄ par rapport au volume total compris entre 3% et 9%,
• le débit d'hydrogène rapporté à la pression de 1 bar est compris entre 20 et 50 litres/min et de préférence 40 litres/min,
• la pression du mélange de gaz dans la chambre est comprise entre 2 et 6 mbar et préférence de 4 mbar,
• La température du substrat est comprise entre 500 et 1000°C,

20. Procédé de dépôt selon l'une des revendications 11 à 19 **caractérisé en ce que** la phase de phase de croissance de diamant microcristallin est mise en oeuvre dans les conditions suivantes :
• durée comprise entre 1 h et 5h
• chauffage respectivement direct ou indirect d'un mélange de gaz CH₄/H₂/X dans lequel X représente un gaz dopant, avec un pourcentage en volume de gaz dopant compris entre 0% et 10%, et avec un pourcentage en volume de CH₄ par rapport au volume total compris entre 0,05% et 1 %,
• le débit d'hydrogène rapporté à la pression de 1 bar est compris entre 30 et 90 litres/min et de préférence 60 litres/min,
• la pression du mélange de gaz dans la chambre est comprise entre 0.5 et 2 mbar et préférence de 1 mbar,
• La température du substrat est comprise entre 500 et 1000°C.
